# EUROPÄISCHE PATENTSCHRIFT

(11) **EP 0 673 546 B1**
(45) Veröffentlichungstag und Bekanntmachung des Hinweises auf die Patenterteilung: **16.06.1999**
(21) Anmeldenummer: 94900076.4
(22) Anmeldetag: 25.10.1993
(51) Int. Cl.: H01L 21/316, H01L 21/318, H01L 21/205

(54) **VERFAHREN ZUR HERSTELLUNG VON HALBLEITER- UND ISOLIERSCHICHTEN**
METHOD OF PRODUCING SEMICONDUCTOR AND INSULATION FILMS
PROCEDE D'OBTENTION DE COUCHES SEMICONDUCTRICES ET ISOLANTES

(30) Priorität: 11.12.1992 DE 4241840
(43) Veröffentlichungstag der Anmeldung: 27.09.1995
(73) Patentinhaber: Heraeus Noblelight GmbH, 63450 Hanau (DE)
(72) Erfinder: KOGELSCHATZ, Ulrich, CH-5212 Hausen (CH)
(74) Vertreter: Staudt, Armin Walter
(86) Internationale Anmeldenummer: EP9302939
(87) Internationale Veröffentlichungsnummer: WO9414189

(56) Entgegenhaltungen:
- EP-A- 0 283 311
- US-A- 5 123 995
- EXTENDED ABSTRACTS OF THE 20TH INTERNATIONAL CONFERENCE ON SOLID STATE DEVICES AND MATERIALS. AUGUST 24-26 1988 TOKYO JP Seiten 61 - 64 T.TANAKA ET AL. 'SELECTIVE GROWTH OF POLYCRYSTALLINE SILICON BY LASER-INDUCED CRYOGENIC CVD'

## Beschreibung

Die Erfindung bezieht sich auf ein Verfahren zur Herstellung von Halbleiter- und Isolierschichten auf Substraten gemäß dem Oberbegriff des Patentanspruches 1.

Die mit dem Verfahren hergestellten halbleitenden Schichten finden ihre Anwendung in Solarzellen oder bei der Herstellung von Dünnfilmtransistoren. Die isolierenden Schichten eignen sich als Versiegelung oder Passivierung von Halbleiterbauelementen.

Der Erfindung liegt die Aufgabe zugrunde, ein Verfahren anzugeben, mit dem dünne Halbleiter- und Isolierschichten auf einfachere Weise als bisher gefertigt werden können.

Diese Aufgabe wird erfindungsgemäß durch die Merkmale des Patentanspruches 1 gelöst.

Mit dem erfindungsgemäßen Verfahren ist es auf einfache Weise möglich, auf einem Substrat zunächst einen festen oder flüssigen Film abzuscheiden, der eine metallische oder nichtmetallische Komponente in Form einer silizium-, gallium-, germanium-oder arsenhaltigen Verbindung aufweist. Die Schicht wird mit Hilfe einer Verbindung hergestellt, die bei Raumtemperatur und Atmosphärendruck gasförmig ist, und eine der obengenannten Komponenten aufweist. Die gasförmige Verbindung wird mit Hilfe eines Trägergases über die Oberfläche des Substrats geleitet und dort abgeschieden. Das Substrat befindet sich in einem Reaktor und wird auf einer Temperatur gehalten, die unterhalb von 0°C liegt. Vorzugsweise wird eine Temperatur gewählt, bei der sichergestellt ist, daß sich durch das Abscheiden der gasförmigen Verbindung eine flüssige oder feste Schicht bilden kann. Dem Trägergas können zur Bildung von Oxiden, Nitriden oder Karbiden Sauerstoff, Stickstoff, Stickstoffdioxid oder Ammoniak bzw. Kohlenwasserstoff beigemischt werden. Die Ausbildung von Si-H wird durch eine gezielte Zufuhr von Wasserstoff erreicht. Zur Ausbildung einer siliziumhaltigen Schicht werden vorzugsweise Silane in Form von SiH₄, Si₂H₆ mit dem Trägergas der Oberfläche des zu beschichtenden Substrats zugeführt. Hat die abgeschiedene Schicht die gewünschte Dicke erreicht, so wird die Schicht der Bestrahlung mit UV-Photonen ausgesetzt, die eine Wellenlänge zwischen 70 nm und 170 nm aufweisen. Durch die Bestrahlung wird die in der Verbindung enthaltene Silizium-, Germanium-, Gallium- oder Arsen-Komponente durch UV-Photonen gespalten. Erfindungsgemäß besteht die Möglichkeit, zwischen der UV-Quelle und der Schicht eine Maske anzuordnen, so daß auch eine partielle Bestrahlung der Schicht möglich ist. Durch eine anschließende Temperaturerhöhung, können die nicht bestrahlten Schichtteile vedampft werden.

Weitere erfindungswesentliche Merkmale sind in den Unteransprüchen gekennzeichnet.

Die Erfindung wird nachfolgend anhand von schematischen Zeichnungen näher erläutert.

Es zeigen:
- Fig. 1: eine Vorrichtung zur Herstellung von Halbleiter- und Isolierschichten,
- Fig. 2: eine Variante der in Fig. 1 dargestellten Vorrichtung.

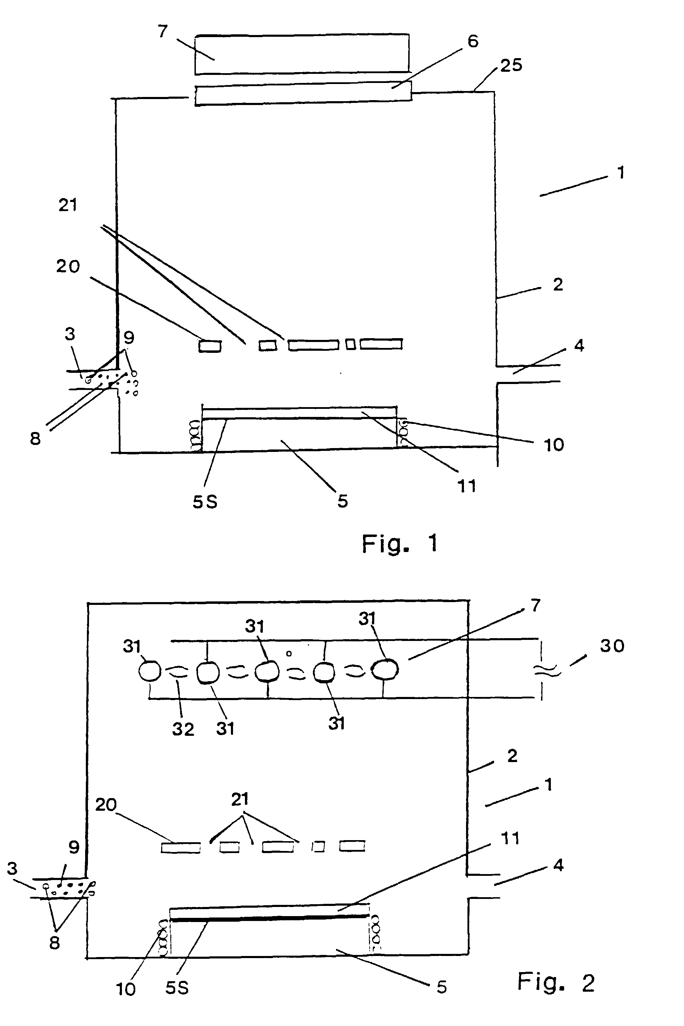

Fig. 1 zeigt eine Vorrichtung 1, die im wesentlichen durch einen Reaktor 2 gebildet wird. Diese Vorrichtung ist nicht Teil der beanspruchten Erfindung. Dieser weist eine Zuleitung 3 und eine Ableitung 4 auf. Im unteren Bereich des Reaktors 2 ist ein zu beschichtendes Substrat 5 angeordnet. Das Substrat 5 ist so positioniert, daß es unterhalb eines Fensters 6 angeordnet ist, das in der Begrenzungsfläche 2S des Reaktors 2 installiert ist, die dem Substrat 5 gegenüberliegt. Über dem Fenster 6 ist eine UV-Strahlungsquelle 7 angeordnet. Zur Beschichtung des Substrats mit einer Halbleiter- oder Isolierschicht wird über die Zuleitung 3 eine gasförmige Verbindung 8 zusammen mit einem Trägergas 9 in den Reaktor 2 eingeleitet. Als Trägergas 9 kann beispielsweise Argon verwendet werden. Soll auf dem Substrat 5 eine siliziumhaltige Schicht ausgebildet werden, so wird mit Hilfe des Trägergases 8 Silan in Form von SiH₄ oder Si₂H₆ über die Oberfläche 5S des Substrats 5 geleitet. Zur Ausblidung einer germanium- oder arsenhaltigen Schicht wird GeH4 oder AsH3 zusammen mit einem Trägergas 8 auf die Oberfläche 5S des Substrates 5 geleitet. Das Substrat 5 kann aus jedem organischen oder anorganischen Werkstoff gefertigt werden, der bei Temperaturen bis -150°C beständig ist. Vorzugsweise wird das Substrat 5 aus einem keramischen Material beispielsweise Al₂0₃ gefertigt. Das Substrat 5 ist von einer Kühlvorrichtung 10 umgeben, die es gestattet, das Substrat 5 auf eine Temperatur von -135°C zu kühlen. Die mit Hilfe des Trägergases 8 in den Reaktor 2 eingeleitete gasförmige Verbindung 9 wird auf der gekühlten Oberfläche 5S des Substrats 5 in Form Schicht 11 abgeschieden. Hat diese die gewünschte Dicke erreicht, so wird die Zuleitung der gasförmigen Komponenten 8 und 9 unterbrochen. An die Abscheidung der Schicht 11 schließt sich deren Bestrahlung mit UV-Photonen an. Als UV-Strahlungsquelle kann beispielsweise ein UV-Hochleistungsstrahler 7 verwendet werden, wie er in der EP-OS 02 54 111 beschrieben ist. Dieser UV-Hochleistungsstrahler 7 besteht aus einem durch eine einseitig gekühlte Metallelektrode (hier nicht dargestellt) und ein Dielektrikum (hier ebenfalls nicht dargestellt) begrenzten und mit einem Edelgas oder einem Gasgemisch gefüllten Entladungsraum ( hier nicht dargestellt). Das Dielektrikum und die auf der dem Entladungsraum angewandten Oberfläche des Dielektrikums liegende zweite Elektrode sind für die durch stille elektrische Entladung erzeugte Strahlung transparent. Durch diese Konstruktion und durch eine geeignete Wahl der Gasfüllung wird ein großflächiger UV-Hochleistungsstrahler 7 mit hohem Wirkungsgrad geschaffen. Mit Hilfe einer Gasfüllung aus Helium bzw. Argon kann eine UV-Strahlung mit einer Wellenlänge zwischen 60 und 100 nm bzw. 107 und 165 nm erzeugt werden. Vorzugsweise wird als Gasfüllung Neon, Argon, Krypton oder Xenon verwendet, deren Strahlungsmaxima bei ungefähr 90 nm, 130 nm 150 nm und 170 nm liegen. Durch die Anordnung einer Maske 20, zwischen dem UV-Hochleistungsstrahler 7 und dem Stubstrat 5 ist es möglich, die Schicht 11 nur partial zu bestrahlen, und zwar in den Bereichen, in denen die Maske 20 mit Durchlässen 21 versehen ist. Durch die Bestrahlung wird das in der Schicht 11 enthaltene Silizium freigesetzt. Wird mit dem Trägergas 8 und der gasförmigen Verbindung 9 zusätzlich Sauerstoff in den Reaktor 2 eingeleitet, so kann das Silizium hiermit reagieren und es kommt zur Bildung einer dielektrischen Siliziumoxidschicht. Durch Einleitung von Stickstoff oder Kohlenstoff ist auch die Bildung von Siliziumnitridschichten oder Siliziumkarbidschichten möglich. Durch Erhöhung der Substrattemperatur können die nichtbestrahlten Bereiche der Schicht 11 verdampft und über die Ableitung 4 aus dem Reaktor 2 entfernt werden.

Erfindungsgemäß besteht die Möglichkeit, anstelle einer siliziumhaltigen Verbindung 9 mit dem Trägergas 8 auch eine germaniumhaltige, galliumhaltige oder arsenhaltige Verbindung 9 in den Reaktor 2 einzuleiten.

Fig. 2 zeigt eine zur Erfindung gehörigen Variante des in Fig. 1 dargestellten Vorrichtung 1. Bis auf die Strahlungsquelle 7 und deren Anordnung bestehen keine Unterschiede gegenüber der Anordnung gemäß Fig. 1. Der hier verwendete UV-Strahler 7 ist innerhalb des Reaktors 2 angeordnet und an eine Hochspannungsquelle 30 angeschlossen. Der UV-Strahler 7 wird durch mehrere in definiertem Abstand voneinander angeordnete Elektroden 31 gebildet, die als Hohlzylinder ausgebildet und aus Glas oder einem Metall gefertigt sind, das mit einem Dilektrkum beschichtet ist. Eine detaillierte Beschreibung dieses UV-Strahlers 7 ist in der DE-OS 39 19 538 offenbart. Wird zwischen die Elektroden 31, zwischen denen jeweils ein Spalt 32 vorgesehen ist, ein Gas eingeleitet, so kommt es zu einer stillen Entladung. Dabei wird UV-Strahlung mit einer Wellenlänge, je nach Art des eingeleiteten Gases, zwischen 70 nm und 170 nm erzeugt. Da für die Einleitung der gasförmigen Verbindung 9 beispielsweise Argon als Trägergas 8 verwendet wird, bewirkt dieses Gas eine stille Entladung in den Spalten 32 zwischen den Elektroden 31, wodurch es zur Bildung von UV-Strahlung kommt, mit der die auf dem Substrat 5 abgeschiedene Schicht 11 vollständig oder durch Zwischenfügen einer Maske 20 bestrahlt werden kann.

## Patentansprüche

1. Verfahren zur Herstellung von Halbleiter- und Isolierschichten, wobei eine unter Normalbedingungen gasförmige Verbindung (9), die wenigstens eine Komponente in Form von Silizium, Gallium, Germanium oder Arsen aufweist, zusammen mit einem Trägergas (8) der Oberfläche (5S) eines auf einer Temperatur unterhalb von 0° C gehaltenen in einem Reaktor angeordneten Substrats (5) zugeleitet wird, und wobei die auf dem Substrat (5) abgeschiedene Schicht (11) anschließend vollständig oder partiell mit UV-Photonen einer definierten Wellenlänge bestrahlt wird, dadurch gekennzeichnet, daß zur Bestrahlung ein UV-Hochleistungsstrahler eingesetzt wird, der UV-Photonen mit einer Wellenlänge im Bereich zwischen 60 und 170 nm erzeugt, und der innerhalb des Reaktors angeordnet ist.

2. Verfahren nach Anspruch 1, dadurch gekennzeichnet, daß das Trägergas nach der Abscheidung der Schicht (11) zur Erzeugung der UV-Strahlung in einer stillen Entladung in den Spalten (32) zwischen den Elektroden (31) dient.

3. Verfahren nach Anspruch 1 oder 2, dadurch gekennzeichnet, daß in den Reaktor (2) das Trägergas (8) zusammen mit der gasförmigen Verbindung (9) eingeleitet wird.

4. Verfahren nach einem der Ansprüche 1 bis 3, dadurch gekennzeichnet, daß unbestrahlte Bereiche der auf dem Substrat (5) abgeschiedenen Schicht (11) verdampft und aus dem Reaktor (2) entfernt werden.

5. Verfahren nach einem der Ansprüche 1 bis 4, dadurch gekennzeichnet, daß das Substrat (5) auf einer Temperatur zwischen 0 und -130° C gehalten wird.

6. Verfahren nach einem der Ansprüche 1 bis 5, dadurch gekennzeichnet, daß zur Ausbildung einer siliziumhaltigen Schicht (11) SiH₄ oder Si₂H₆ zusammen mit einem Trägergas (8) der Oberfläche (5S) eines Substrats (5) zugeführt werden.

7. Verfahren nach einem der Ansprüche 1 bis 6, dadurch gekennzeichnet, daß zur Ausbildung einer germaniumhaltigen Schicht (11) GeH4 zusammen mit einem Trägergas der Oberfläche (5S) des Substrates (5) zugeführt wird.

8. Verfahren nach einem der Ansprüche 1 bis 7, dadurch gekennzeichnet, daß das zur Ausbildung einer arsenhaltigen Schicht (11) AsH3 zusammen mit einem Trägergas der Oberfläche (5S) des Substrates (5) zugeführt wird.

9. Verfahren nach einem der Ansprüche 1 bis 8, dadurch gekennzeichnet, daß dem Trägergas Wasserstoff, Sauerstoff, Stickstoffdioxid, Stickstoff, Ammoniak oder Kohlenwasserstoff zur Ausbildung von wasserstoffhaltigen amorphen Siliziumschichten, zur Bildung von Oxiden, Nitriden oder Karbiden beigemischt werden.

## Claims

1. Method of producing semiconductor and insulating films, wherein a compound (9) which is gaseous under normal conditions and which contains at least one component in the form of silicon, gallium, germanium or arsenic is fed, together with a carrier gas (8), to the surface (5S) of a substrate (5) kept at a temperature below 0°C and arranged in a reactor, and wherein the film (11) deposited on the substrate (5) subsequently is completely or partially irradiated with UV radiation of a defined wavelength, characterized in that a high-power UV emitter which produces UV radiation having a wavelength in the range between 60 and 170 nm and which is arranged inside the reactor is used for the irradiation.

2. Method according to Claim 1, characterized in that, after deposition of the film (11), the carrier gas serves for generating the UV radiation in a silent discharge in the gaps (32) between the electrodes (31).

3. Method according to Claim 1 or 2, characterized in that the carrier gas (8) is passed, together with the gaseous compound (9), into the reactor (2).

4. Method according to any of Claims 1 to 3, characterized in that unirradiated regions of the film (11) deposited on the substrate (5) vaporize and are removed from the reactor (2).

5. Method according to any of Claims 1 to 4, characterized in that the substrate (5) is kept at a temperature between 0 and -130°C.

6. Method according to any of Claims 1 to 5, characterized in that, for the formation of a silicon-containing film (11), SiH₄ or Si₂H₆ is fed, together with a carrier gas (8), to the surface (5S) of a substrate (5).

7. Method according to any of Claims 1 to 6, characterized in that, for the formation of a germanium-containing film (11), GeH₄ is fed, together with a carrier gas, to the surface (5S) of the substrate (5).

8. Method according to any of Claims 1 to 7, characterized in that, for the formation of an arsenic-containing film (11) AsH₃ is fed, together with a carrier gas, to the substrate (5S) of the substrate (5).

9. Method according to any of Claims 1 to 8, characterized in that, for the formation of hydrogen-containing amorphous silicon films, hydrogen, oxygen, nitrogen dioxide, nitrogen, ammonia or hydrocarbon is mixed with the carrier gas, for the formation of oxides, nitrides or carbides.

## Revendications

1. Procédé de fabrication de couches isolantes et semiconductrices, une liaison gazeuse (9) en conditions normales qui présente au moins un composant de silicium, de gallium, de germanium ou d'arsenic, étant amenée ensemble avec un gaz porteur (8) à la surface (5S) d'un substrat (5) disposé dans un réacteur et maintenu à une température inférieure à 0°C et la couche (11) précipitée sur le substrat (5) étant ensuite partiellement ou entièrement exposée aux photons UV d'une longueur d'ondes définie, caractérisé en ce que pour l'irradiation, on a recours à un radiant UV haute puissance qui génère des Photons UV d'une longueur d'ondes comprise entre 60 et 170 nm et qui est disposé à l'intérieur du réacteur.

2. Procédé selon la revendication 1, caractérisé en ce que le gaz porteur après la précipitation de la couche (11) sert à la production du rayonnement UV dans une décharge silencieuse dans les interstices (32) entre les électrodes (31).

3. Procédé selon la revendication 1 ou 2, caractérisé en ce que le gaz réacteur (8) est amené dans le réacteur (2) en même temps que la liaison gazeuse (9).

4. Procédé selon l'une des revendications 1 à 3, caractérisé en ce que des zones non atteintes par le rayonnement de la couche précipitée (11) sur le substrat (5) sont évaporées et sont éliminées du réacteur (2).

5. Procédé selon l'une des revendications 1 à 4, caractérisé en ce que le substrat (5) est maintenu à une température comprise entre 0 et - 130°C.

6. Procédé selon l'une des revendications 1 à 5, caractérisé en ce que pour la formation d'une couche à base de silicium (11), du SiH₄ ou Si₂H₆ sont amenés avec un gaz porteur (8) à la surface (5S) d'un substrat (5).

7. Procédé selon l'une des revendications 1 à 6, caractérisé en ce que pour la formation d'une couche à base de germanium (11), du GeH₄ est amené avec un gaz porteur à la surface (5S) d'un substrat (5).

8. Procédé selon l'une des revendications 1 à 7, caractérisé en ce que pour la formation d'une couche à base d'arsenic (11) du AsH₃ est amené avec un gaz porteur à la surface (5S) d'un substrat (5).

9. Procédé selon l'une des revendications 1 à 8, caractérisé en ce que le gaz porteur est mélangé à de l'hydrogène, de l'oxygène, du dioxyde d'azote, de l'azote, de l'ammoniaque ou des hydrocarbures pour la réalisation de couches de silicium amorphe contenant de l'hydrogène en vue d'obtenir des oxydes, des nitrures ou des carbures.
